# EUROPÄISCHE PATENTSCHRIFT

(11) **EP 2 925 901 B1**
(45) Veröffentlichungstag und Bekanntmachung des Hinweises auf die Patenterteilung: **23.08.2023**
(21) Anmeldenummer: 13826558.2
(22) Anmeldetag: 28.11.2013
(51) Int. Cl.: C23C 14/32, C23C 14/06, C22C 27/04, H01J 37/32

(54) **VERFAHREN ZUR STRUKTURIERUNG VON SCHICHTOBERFLÄCHEN UND BESCHICHTESTES SUBSTRAT**
METHOD FOR STRUCTURING LAYER SURFACES AND COATED SUBSTRAT
PROCÉDÉ POUR STRUCTURER DES SURFACES DE COUCHES ET SUBSTRAT REVETU

(30) Priorität: 29.11.2012 DE 102012023260
(43) Veröffentlichungstag der Anmeldung: 07.10.2015
(73) Patentinhaber: Oerlikon Surface Solutions AG, Pfäffikon, 8808 Pfäffikon SZ (CH)
(72) Erfinder: RAMM, Jürgen, CH-7304 Maienfeld (CH); WIDRIG, Beno, CH-7310 Bad Ragaz (CH); SOBIECH, Matthias, Lukas, 88142 Wasserburg (DE); FOPP-SPORI, Doris, CH-7302 Landquart (CH)
(74) Vertreter: Troesch Scheidegger Werner AG
(86) Internationale Anmeldenummer: PCT/EP2013/003595
(87) Internationale Veröffentlichungsnummer: WO 2014/082746

(56) Entgegenhaltungen:
- EP-A1- 0 668 369
- EP-A2- 2 042 261
- WO-A1-2012/078151
- WO-A1-2012/102374
- JP-A- 2005 153 072
- US-B2- 8 304 098
- POHLER M ET AL: "Cathodic arc deposition of (Al,Cr)O: Macroparticles and cathode surface modifications", SURFACE AND COATINGS TECHNOLOGY, ELSEVIER, AMSTERDAM, NL, Bd. 206, Nr. 6, 12. September 2011 (2011-09-12), Seiten 1454-1460, XP028333552, ISSN: 0257-8972, DOI: 10.1016/J.SURFCOAT.2011.09.028 [gefunden am 2011-09-19]
- OZTURK ET AL: "Comparative tribological behaviors of TiN?, CrN? and MoN?Cu nanocomposite coatings", TRIBOLOGY INTERNATIONAL, BUTTERWORTH SCIENTIFIC LDT, GUILDFORD, GB, Bd. 41, Nr. 1, 18. September 2007 (2007-09-18), Seiten 49-59, XP022257470, ISSN: 0301-679X, DOI: 10.1016/J.TRIBOINT.2007.04.008
- SUSZKO T ET AL: "Mo2N/Cu thin films - the structure, mechanical and tribological properties", SURFACE AND COATINGS TECHNOLOGY, ELSEVIER, AMSTERDAM, NL, Bd. 200, Nr. 22-23, 20. Juni 2006 (2006-06-20), Seiten 6288-6292, XP024995791, ISSN: 0257-8972, DOI: 10.1016/J.SURFCOAT.2005.11.041 [gefunden am 2006-06-20]

## Beschreibung

Die vorliegende Erfindung bezieht sich auf ein Verfahren zur Beschichtung von Substraten mittels Funkenverdampfen, mit dem eine strukturierte Oberfläche erreicht werden soll. Strukturierte Oberflächen mit Strukturgrössen im Mikrometer- und Nanometerbereich werden in verschiedenen Anwendungsbereichen benötigt. Bekannt sind beispielsweise die Strukturen die auf Siliziumwafern erzeugt werden, um Halbleiterbauelemente herzustellen. Diese Strukturen werden durch aufwendige lithografische Verfahren realisiert und bestehen aus mehreren Prozessschritten. Es gibt auch Verfahren bei denen die Oberflächenstrukturierung mittels Laser erfolgt oder durch einen fokussierten lonenstrahl. Diese Verfahren bedingen ebenfalls einen grossen technologischen Aufwand. In die WO2003091474 offenbaren Massler et al ein solches strukturiertes Schichtsystem für Werkstücke, insbesondere für Werkzeuge oder Bauteile mit einer als Gleitfläche ausgebildeten Funktionsfläche. Weiterer relevanter Stand der Technik ist offenbart in den Patentdokumenten US 8 304 098 B2, EP 2 042 261 A2 und WO 2012/078151 A1.

Aus Kostengründen werden die oben angeführten Verfahren nicht oder nur in ausgewählten Fällen zur Strukturierung von Oberflächen für tribologische Anwendungen beispielsweise auf dem Gebiet beschichteter Werkzeuge oder Bauteile oder zur Einstellung der Benetzbarkeit von Oberflächen auf Substraten, die beispielsweise aus Kunststoff sind, eingesetzt. Dabei wäre eine solche Strukturierung in vielen Fällen und für wesentlich breitere Anwendungsbereiche wünschenswert und von wirtschaftlicher Bedeutung. Beispielsweise könnten die "Täler" in einer solchermassen strukturierten Oberfläche als Reservoir für Schmiermittel dienen, was als Folge den Reibwert verringert, Reibungsverluste verkleinert und letztlich in reduziertem Energieaufwand endet. Als Schmiermittel käme beispielsweise ein Schmierstoff in Frage, also beispielsweise ein Oel oder Fett. Aber auch in Kombination mit niedrigschmelzenden Materialien können solchermassen strukturierte Oberflächen besonders mit Hinblick auf die Optimierung tribologischer Systeme bei erhöhten Temperaturen hilfreich sein. Die Materialien mit niedrigen Schmelzpunkten können, abhängig von den Kontaktbedingungen, verflüssigt werden und eine ähnliche Funktion übernehmen wie die Oele und Fette, nur eben bei erhöhten Temperaturen. "Tälerstrukturen" können aber auch nützlich sein, um Benetzungsmechanismen einzustellen, d.h. könnten dazu dienen, dass man diese beispielsweise im Bereich dekorativer Oberflächen oder für Oberflächen für medizinische Anwendungen anwenden könnte.

### BESTÄTIGUNGSKOPIE

Es sind allerdings nicht nur die ökonomische Aspekte, die eine Anwendung der oben beschriebenen Verfahren in breiterem Umfang für tribologische Anwendungen verhindern. Die lithografischen Strukturiermethoden in der Halbleitertechnologie sind zum Beispiel für ein Substratmaterial, nämlich Silizium, und für ein Material, das strukturiert werden soll, nämlich Si02, entwickelt worden. Materialänderungen bedingen wieder komplett neue Strukturierverfahren, z.B. Plasmaätzverfahren [Sze 1, pp. 304) zum Strukturieren von Nitriden oder metallischen Leiterbahnen bei den Halbleitern. Es ist verständlich, dass dies bei tribologischen Anwendungen kaum realisiert werden kann. Die Mannigfaltigkeit der metallischen und der verschiedenartigsten keramischen Substratmaterialien lassen das in grossem Rahmen gar nicht zu.

In «Cathodic arc deposition of (Al,Cr)2O3: Macroparticles and cathode surface modifications», Surface & Coatings Technology 206 (2011) 1454-1460, wurden entsprechende Schichten untersucht wobei zwei unterschiedliche, d.h. kugelförmige und halbkugelförmige in der Schicht eingebaut und teilweise von einem dichten Film überwachsen Dropletspezies gefunden wurden.

In der EP2042261A2 wird ein Verfahren offenbart, um in mehreren einem Funkenverdampfungsprozess in der Beschichtungskammer dazwischengeschalteten lonenätzschritten glattere Schichten für Schneidwerkzeuge herzustellen, als dies mit einem Funkenverdampfungsprozess alleine oder lediglich nachgeschaltetem Behandlungsschritt möglich wäre.

### Ziele der Erfindung

Ein Ziel der Erfindung 1st es also, dass eine vom Substratmaterial weitgehend unabhängige strukturierte Substratoberflache hergestellt werden kann.

Ein weiteres Ziel der Erfindung ist es, dass die Struktureigenschaften der Oberfläche durch das Herstellungsverfahren verändert und optimiert werden können, also beispielsweise die Oberflächendichte der Strukturen oder deren Dimension.

Ein weiteres Ziel dieser Erfindung 1st es, dass die Strukturierung entweder keinen weiteren Prozessschritt erfordert oder lediglich geringer Nachbehandlungsaufwand durchgeführt werden muss, urn die gewünschten Strukturen zu erhalten.

Ein spezielles (ohne sich dabei auf diesen Anwendungsbereich einzuschränken) weiteres Ziel der Erfindung ist es, zu erreichen, dass eine solche Oberfläche neben einer hohen Verschleissfestigkeit sehr niedrige Reibwerte aufweist, d.h. dass sie sich zur Optimierung tribologischer Systeme einsetzen lässt.

Ein weiteres spezielles Ziel der Erfindung ist es, die Oberflächentopografie durch aufbringen einer solchen Schicht so zu verändern, dass die Benetzungseigenschaften gezielt verändert werden können.

Ein weiteres Ziel der Erfindung ist es, dass die Strukturierung gleichzeitig mit der Abscheidung einer dünnen Schicht erfolgt, bzw. dass die abgeschiedene Schicht die Struktur formiert.

### Erfinderische Lösung

Die Erfindung ist definiert durch das Verfahren gemäß Anspruch 1 und durch ein mit einem Schichtsystem beschichtetes Substrat gemäß Anspruch 10.

Die Aufgabenstellung wird durch eine PVD-Beschichtung mittels kathodischer Funkenverdampfung gelöst, bei der ein Target als Kathode verwendet wird, dessen chemische Zusammensetzung die Oberflächenstrukturierung ermöglicht.

Die Aufgabe wird erfindungsgemäss dadurch gelöst, dass die Zusammensetzung des Targets aus mindestens zwei Elementen besteht, wobei eines davon niederschmelzend und eines davon hochschmelzend ist.

Die das Target bildenden Komponenten sollten aus mindestens zwei Elementen sein, die sehr unterschiedlich bezüglich ihres Dampfdruckes bei ca. 1Pa sind.

Die das Target bildenden Komponenten sollten ausserdem mindestens zwei Elemente umfassen, die sehr unterschiedlich bezüglich ihres Schmelzpunktes sind.

Mit der Erfindung gelingt die Herstellung einer strukturierten Schicht auf einem Substratmaterial, das mittels Funkenverdampfung beschichtet werden kann, d.h. dass Substratmaterialien aus einer Vielzahl von metallischen und keramischen Materialien ausgewählt werden können und sogar Kunststoffmaterialien in Frage kommen.

Die strukturierte Schicht kann sowohl metallischer Natur sein oder eine Kombination zwischen keramischer und metallischer Natur, also beispielsweise ein Nitrid, Karbid oder Oxid und Kombinationen aus diesen Materialien umfassen.

Die Erfindung basiert auf Strukturen, die in eine Matrixschichtoberfläche während der Beschichtung eingebracht werden, wobei es sich um "Talstrukturen" (konkav) mit annähernd kreisförmigen Querschnitt handelt. Die Dichte, die Tiefe und der Durchmesser dieser Strukturen kann durch die das Target umfassenden Komponenten festgelegt werden.

Die Erfindung beruht zum einen darauf, dass am Target mit der entsprechenden Targetzusammensetzung vermehrt und reproduzierbar Spritzer gebildet werden und zum anderen darauf, dass am Substrat diese Spritzer lediglich nur lose in die aufwachsende Schicht eingebaut werden und entweder selbständig während des Schichtwachstums aus der Schicht herausgedrückt werden oder nachträglich durch eine einfache Nachbehandlung entfernt werden können.

Ein weiterer Aspekt der Erfindung, der vor allem für tribologische Anwendungen von Bedeutung ist, ist die eingeschränkte Löslichkeit der niederschmelzenden Targetkomponente in der hochschmelzenden Targetkomponente.

### Beschreibung der Erfindung

Die kathodische Funkenverdampfung ist ein dem Fachmann bestens bekanntes Verfahren zur Beschichtung von unterschiedlichen Substraten und Substratmaterialien mit dünnen Schichten. Bei diesem Verfahren wird ein Target als Kathode einer Funkenentladung geschaltet und durch die Wirkung des auf dem Target betriebenen Funkens das Targetmaterial verdampft. Ausführlich können die Grundlagen dieses Beschichtungsverfahrens in der Literatur nachgelesen werden. Die kathodische Funkenverdampfung erlaubt sowohl die Herstellung metallischer Schichten (also eine Verdampfung des Targetmaterials ohne Reaktivgas) wie auch die Herstellung keramischer Schichten unter Verwendung von Reaktivgasen wie beispielsweise Stickstoff, Sauerstoff, Kohlenwasserstoffen, Si-haltigen Gasen. Wird also beispielsweise ein Mo-Target (Mo steht für Molybdän) mittels des kathodischen Funkens in einer Stickstoffatmosphäre verdampft, bildet sich auf der Substratoberfläche eine Mo-N-Schicht, deren Zusammensetzung und Phasen von Prozessparameter wie beispielsweise dem Stickstofffluss, der Mo-Verdampfungsrate, der Substrattemperatur u.ä. abhängt. Eine solche Schicht kann eine grosse Härte besitzen (zwischen 15 Gpa und 35 GPa) und kann bei Anwendungen auf dem Gebiet des Verschleissschutzes auf Werkzeugen und Komponenten eingesetzt werden.

Falls man bei der kathodischen Funkenverdampfung kein elementares Taget wie das vorher beschriebene Mo-Target benutzt, sondern ein Target das aus zumindest zwei Elementen besteht (sog. Mischtarget), so werden diese zumindest beiden Elemente entsprechend auch in die Schichtsynthese eingehen. Für verschleissmindernde Anwendungen auf Werkzeugen und Bauteilen werden beispielsweise TiAIN- und AlCrN-Schichten üblicherweise mit den entsprechenden Mischtargets bestehend aus Al-Ti oder Al-Cr hergestellt. Diese Verschleissschutzschichten sind dem Fachmann bestens bekannt.

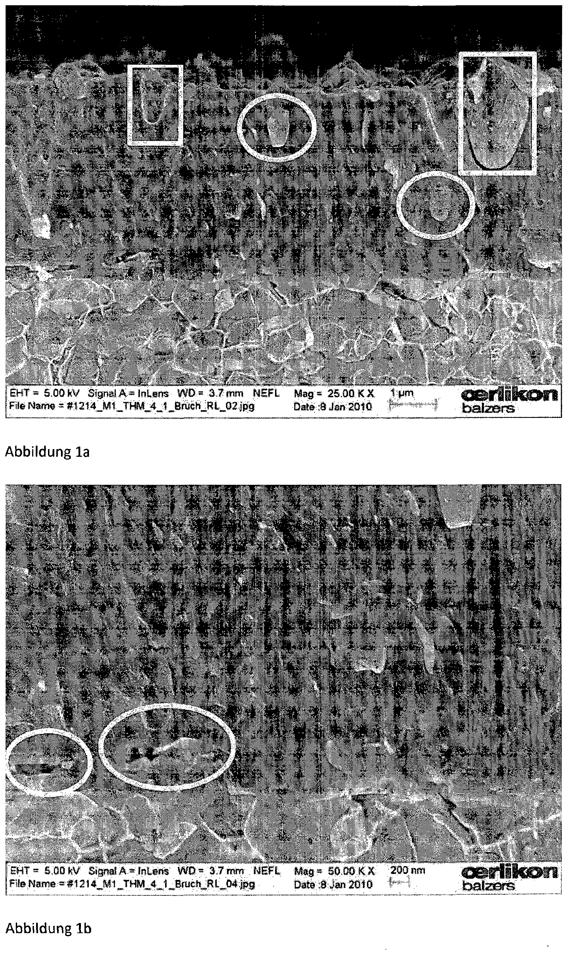

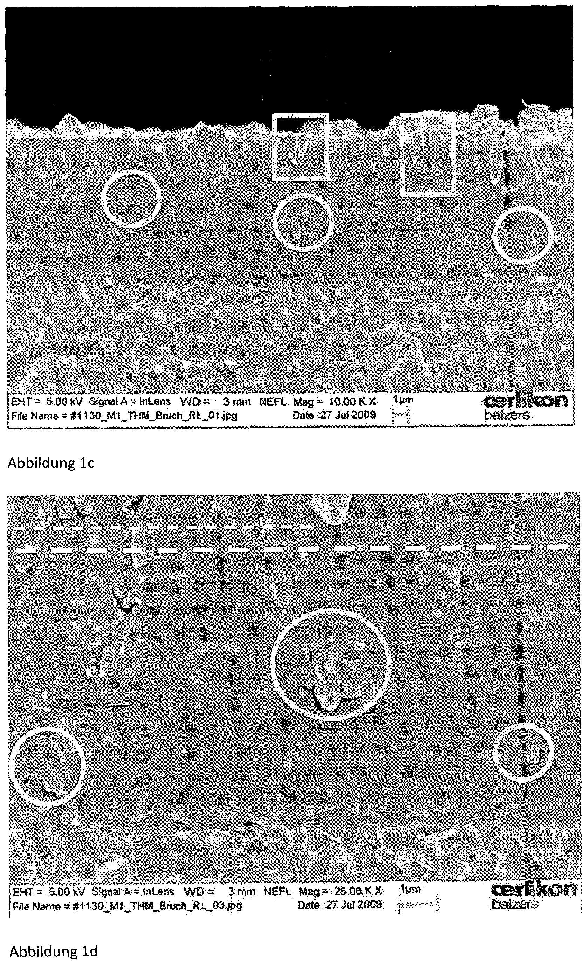

Die reaktive kathodische Funkenverdampfung ist also eine bereits breit in die Produktion eingeführte Beschichtungstechnologie. Neben den vielen Vorteilen dieser Technologie, gibt es aber auch einen allgemein anerkannten grossen Nachteil: die kathodische Funkenverdampfung produziert während der Verdampfung des Targetmaterials durch den kathodischen Funken eine Anzahl von Spritzern, die in die abgeschiedene Schicht eingebaut werden. Diese Spritzer bedingen in vielen Fällen eine Nachbehandlung der beschichteten Oberflächen. Diese Nachbehandlung ist Stand der Technik seit vielen Jahren und wird beispielsweise für Schneidwerkzeuge eingesetzt, bei denen es vorteilhaft ist, die Oberflächenrauigkeit zu reduzieren, um eine bessere Performance der Werkzeuge zu erzielen. Für die typischen Schichten im Verschleissschutz sind diese Spritzer meist hart und wirken abrasiv auf den Gegenkörper im tribologischen Kontakt. Das ist beispielsweise bei Schneidwerkzeugen kein Nachteil, falls der Ausbruch der Spritzer nicht zum Schichtversagen führt. Die Grösse der Spritzer und deren Einbau in die Schichtmatrix ist unterschiedlich und die Festigkeit des Einbaus in dieselbe im Allgemeinen genügend gut aber nicht wirklich kontrollierbar. Es besteht allgemein der Wunsch nach spritzerfreien Schichten. Da aber typischerweise bei der Funkenverdampfung ohne spezielle Filter immer Spritzer generiert werden, besteht der Wunsch, diese wenigstens "gut" in der Schicht zu verankern, damit sie "überwachsen" werden können im Verlauf der Schichtsynthese. Abbildung 1 a und b zeigen einen Querschnitt durch eine Schicht (hier eine Al-Ni-O Schicht) aufgenommen im Rasterelektronenmikroskop bei unterschiedlichen Vergrösserungen. Die Schicht wurde mittels kathodischer Funkenverdampfung von einem Al-Ni-Mischtarget in Sauerstoffatmosphäre auf einer Wendeschneidplatte bestehend aus Wolframcarbid abgeschieden. Auf der Abbildungen 1a erkennt man, dass die Schichtoberfläche eine grosse Rauigkeit aufweist und im Querschnitt der Schicht kann man Spritzer sehen, die in die Schicht eingebaut sind (eingekreiste Bereiche). Man kann aber auch andere Spritzer beobachten, die noch nicht überwachsen sind und die teilweise beim Brechen der Proben herausgelöst wurden (in Rechtecken). Die Dichte der Spritzer in und auf den Schichten, die mittels ungefilterter Funkentechnologie hergestellt werden hängt u.a. von den Komponenten ab, aus denen die Mischtargets bestehen. Man kann aber im Wesentlichen immer den Einbau von Spritzern in die Schicht beobachten und auch das nachfolgende Überwachsen der Spritzer.

Der Spritzereinbau soll auch noch an einem anderen Schichtsystem gezeigt werden. In den Abbildung 1c und d ist ein Schichtsystem bestehend aus einer Al-Ti-N-Schicht und einer Al-Cr-O-Deckschicht gezeigt. Die Gesamtschichtdicke des Schichtsystems beträgt etwa 10 µm, wobei die obersten ca. 3 µm die Al-Cr-O-Deckschicht sind. Auf den Abbildungen kann man folgendes sehen. Die Spritzerdichte ist offensichtlich geringer im unteren Teil des Schichtsystems, also in der Al-Ti-N-Schicht. Sie erhöht sich beim Übergang (gestrichelte Linie) von der Al-Ti-N-Schicht in die Al-Cr-O-Schicht, wobei vor allem sehr viele Spritzer in diesem Übergangsbereich entstehen. Aber auch hier gilt, dass die Spritzer durch die spätere Schicht überwachsen oder in diese eingebaut werden. In Abbildung 1 d wird der Einbau der Spritzer in die Al-Ti-N-Schicht nochmals bei höherer Vergrösserung gezeigt.

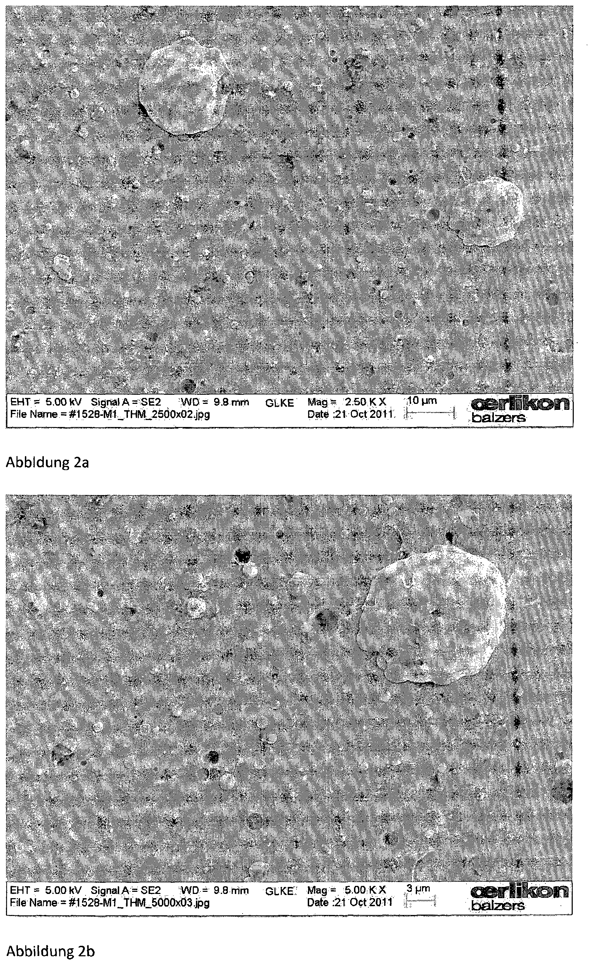

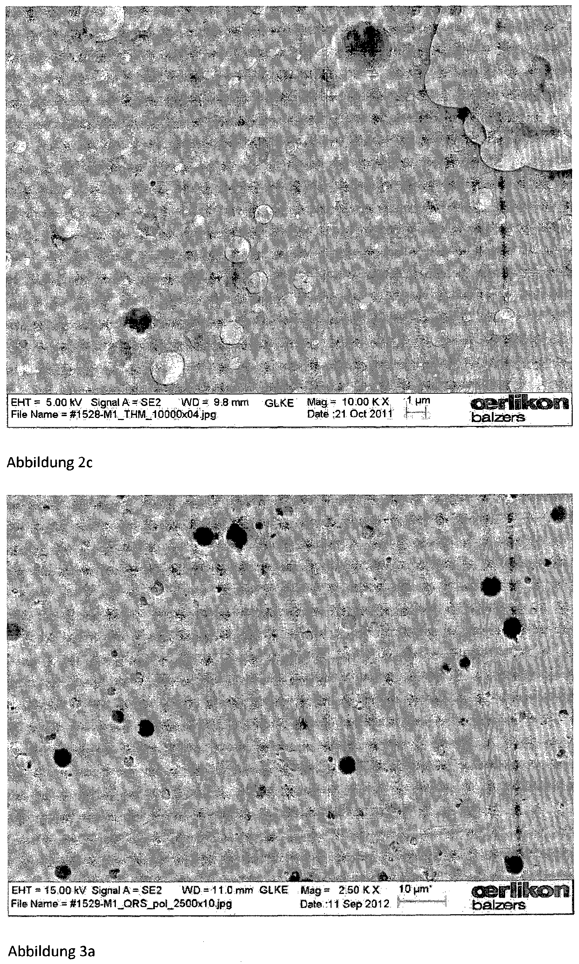

Es war deshalb überraschend, dass es bei der Funkenverdampfung mit Mo(85at.%)-Cu(15at.%)-Mischtargets zu anderen Ergebnissen bezüglich des Einbaus von Spritzern kam. Es wurden Mo-Cu-N-Schichten bei einem Reaktivgasdruck von 4 Pa hergestellt. Es zeigte sich, dass bei der Funkenverdampfung unter Benutzung eines Mo-Cu-Targets durch den kathodischen Funken eine Vielzahl kugelförmiger Spritzer generiert wurde, die nicht in die abgeschiedene Schicht eingebaut wurden. Das erkennt man bei Betrachtung der Abbildungen 2a bis c, die Aufnahmen der Schichtoberfläche im Rasterelektronenmikroskop zeigen. Auf der Schichtoberfläche erkennt man eine Anzahl kugelförmiger Spritzer verschiedenen Durchmessers. Die Durchmesser variieren. Einige haben Durchmesser im Mikrometerbereich und es gibt vergleichsweise wenige grössere Spritzer, deren Durchmesser bis zu etwa 10 Mikrometer gross sein kann. Daneben existieren noch viele kleine Spritzer im Submikrometerbereich, beispielsweise so um die 100 nm oder darunter. In der Abbildung erkennt man auch Lochstrukturen in der Schichtoberfläche. Am deutlichsten sichtbar sind die Lochstrukturen, welche Durchmesser im Mikrometerbereich aufweisen. Diese Lochstrukturen wurden offensichtlich durch jene Spritzer verursacht, deren Haftung zur Schichtmatrix so ungenügend sind, dass sie beim und durch das Schichtwachstum und die dabei auftretenden Kräfte aus der Schicht herausgedrückt wurden. Der genaue Hintergrund für den losen Einbau der Spritzer ist den Erfindern nicht bekannt. Es muss aber angenommen werden, dass das Spritzermaterial die Mo-(Cu)-N-Matrixschicht schlecht benetzt und deshalb die Bildung kugelförmiger Spritzer unterstützt wird. Verbunden damit ist auch die Forderung, dass sich das Spritzermaterial nicht mit dem Matrixmaterial verbindet oder nur schlecht verbindet.

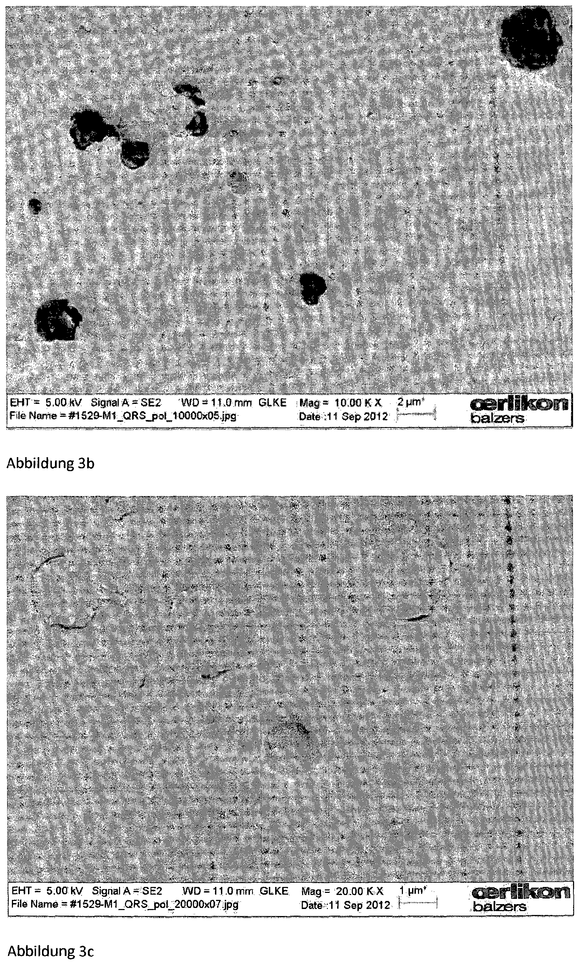

Zusammenfassend kann man sagen, dass sich als Ergebnis der Verdampfung eines Mo-Cu Targets mit dem kathodischen Funken eine Schichtoberfläche ergibt, die charakterisiert ist durch eine Vielzahl (in ihrer Grösse) unterschiedlicher Lochstrukturen, deren Flächendichte im Wesentlichen durch Zahl der Spritzer bestimmt wird. Die Grösse (Durchmesser) der Lochstrukturen hängt von der Grösse der Spritzer ab. Häufigkeit und Grösse der Spritzer bestimmen also wesentlich die Oberflächenstruktur der Schicht. Wichtig für die Strukturierung der Schichtoberfläche ist die Tatsache, dass sich die Mehrzahl der Spritzer nicht oder nur lose in die Schichtoberfläche einbauen. Diese schlechte Haftung der Spritzer in der Matrixschicht führt schon während des Schichtwachstums zu dem Spritzerverlust, der die Lochstrukturen freilegt. Falls diese Spritzer aber dennoch lose haften bleiben, können sie mit einem einfachen Polierschritt entfernt werden. Eine durch einen solchen kurzen Polierschritt behandelte Substratoberfläche ist in den mittels Rasterelektronenmikroskopie abgebildeten Oberflächen einer Mo-Cu-N-Schicht in den Abbildungen 3a bis c dargestellt. Die Abbildungen 3a und b zeigen deutlich, dass die Spritzer entfernt wurden und eine Lochstruktur hinterlassen haben. In Abbildung 3c wird aber auch noch eine andere Möglichkeit gezeigt, was mit den Spritzern nach dem Polierschritt geschehen kann: Falls sie weich genug sind, werden sie teilweise in die Lochstrukturen geschmiert. Vorwiegend kommt es aber zur Entfernung der Spritzer durch den Polierschritt und der daraus resultierenden Oberflächenstrukturierung.

Folgende Bedingungen müssen also erfüllt sein, damit es bei der Beschichtung zu der Oberflächenstrukturierung kommt. Einmal ist ein Verfahren notwendig, dass zuverlässig Spritzer in gewissermassen definierter Form produziert. Das bedeutet, dass während der kathodischen Funkenverdampfung Prozesse an der Targetoberfläche gezielt provoziert werden, die sich eignen, um vermehrt Spritzer auszubilden. Andererseits dürfen sich diese Spritzer nicht fest in die Matrixschicht einbauen, also nicht die Porosität der Schichtmatrix fördern, damit sie schon während des Schichtwachstums entfernt werden oder sich durch eine Nachbehandlung auf einfache Weise und ohne nennenswerte Verluste der Matrixschicht entfernen lassen.

Am Beispiel des Mo-Cu Materialsystems und mit Hilfe der Figuren wird nun versucht, das oben Gesagte näher zu erläutern.

Dabei zeigen die Figuren und Tabellen folgendes:
- Figur 1a: Rasterelektronenmikroskopaufnahme die Querschnitt durch eine AI Ni O Schicht zeigt
- Figur 1b: Aufnahme entsprechend Figur 1a mit anderer Vergrösserung
- Figur 1c: Rasterelektronenmikroskopaufnahme die Querschnitt durch eine AI Ti N Schicht zeigt
- Figur 1d: Aufnahme entsprechend Figur 1c mit anderer Vergrösserung
- Figur 2a: Aufnahme einer Mo-Cu-N Schichtoberfläche im Rasterelektronenmikroskop
- Figur 2b: Vergrösserter Ausschnitt aus 2a
- Figur 2c: Vergrösserter Ausschnitt aus 2b
- Figur 3a: Aufnahme einer polierten Mo-Cu-N Schichtoberfläche im Rasterelektronenmikroskop
- Figur 3b: Aufnahme einer polierten Mo-Cu-N Schichtoberfläche im Rasterelektronenmikroskop bei anderer Vergrösserung als in Figur 3a
- Figur 3c: Aufnahme einer polierten Mo-Cu-N Schichtoberfläche im Rasterelektronenmikroskop
- Figur 4: XRD Rietvelt Analyse an einem ungebrauchten Mo-Cu-Target
- Figur 5a: Ausschnitt einer XRD Analyse eines Mo-Cu Targets nach einstündigem Gebrauch
- Figur 5b: Ausschnitt einer XRD Analyse eines Mo-Cu Targets nach einstündigem Gebrauch
- Figur 6: Phasendiagramm Kupfer Molybdän
- Table 1:: Matrixelemente und Dopingelement.
- Table 2:: Schmelzpunkte und Dampfdruck der Matrixelemente.
- Table 3:: Schmelzpunkte und Dampfdruck der Dopingelemente.
- Table 4:: Niedrigsschmelzende Oxide und Nitride oder solche mit hohem Dampfdruck.

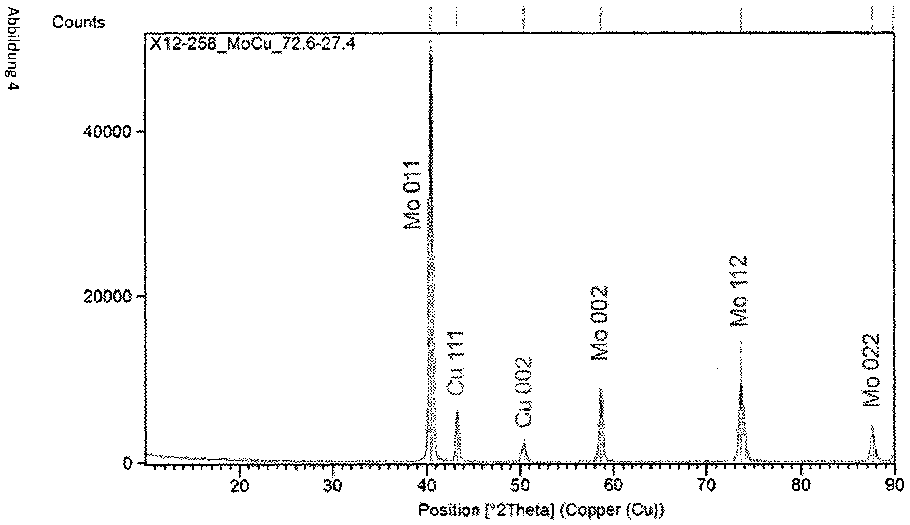

Zuerst sollen die Vorgänge an der Targetoberfläche beschrieben werden. Es ist bekannt, dass aus metallischen Pulvern Mischtargets hergestellt werden können. Die genauen Herstellungsmethoden, nämlich die Verdichtungs- und Temperaturbehandlungen werden spezifisch auf bestimmte Materialkompositionen abgestimmt. Auf diese Weise werden dem Fachmann bekannte Targetkompositionen wie Al-Cr oder Ti-Al hergestellt, mit denen beispielsweise Schichten für den Verschleissschutz von Werkzeugen produziert werden, wie es bereits weiter oben erläutert wurde. Auf eine ganz ähnliche Art wurden nun Mo-Cu-Targets in verschiedener Zusammensetzung hergestellt. Die Erfinder untersuchten Targets mit Cu- gehalten bis zu 30 at.%, wobei auch Targets mit grösseren Cu-Anteile möglich sind. Es wurde von den unbenutzten Targets eine Analyse der Zusammensetzung durchgeführt, sowohl mit EDX, XRF wie auch mit XRD (Rietvelt Analyse). Die jeweils vom Hersteller angegebene Targetzusammensetzung wurde durch diese Analysen bestätigt. Kleinere Abweichungen zwischen den Resultaten aus den Analysenverfahren lassen sich mit den unterschiedlichen Tiefenauflösungen der Analysenmethoden und Abweichungen von der theoretischen Targetdichte erklären. Die XRD-Untersuchungen zeigen klar das Vorhandensein von Mo und Cu an der Targetoberfläche und bis zu den Tiefen, die von den Analysenmethoden erreicht werden, also in der Grössenordnung von einem Mikrometer. Als ein Beispiel wird in Abbildung 4 eine solche XRD Rietvelt Analyse an einem ungebrauchten Mo-Cu-Target gezeigt, für das eine Zusammensetzung von Mo(73at.%)-Cu(27at.%) gefunden wurde, die den Herstellerangaben entsprach. Auf die gleiche Weise wurden die Herstellerangaben an Targets bestätigt für die Nominalzusammensetzungen von Mo(85at.%)-Cu(15at.%) und Mo(95at.%)-Cu(5at.%).

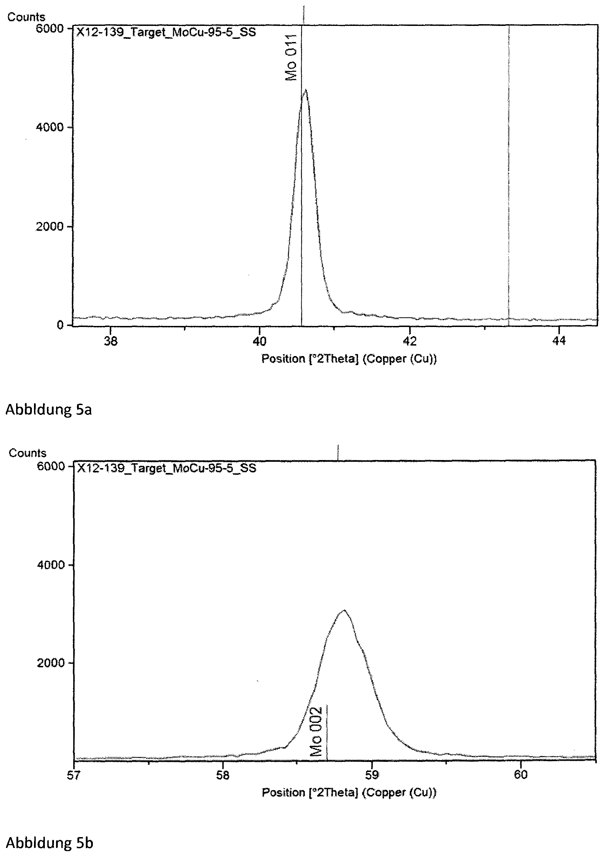

Es wurden nun die Mo-Cu-Targets unterschiedlicher Zusammensetzung ca. 1 h in Stickstoffatmosphäre mit dem kathodischen Funken beaufschlagt. Nach dieser Behandlung wurde die Oberfläche der Mo-Cu-Targets erneut mit XRD analysiert und eine Rietvelt Analyse durchgeführt, um die Zusammensetzung der Targetoberfläche bezüglich Mo und Cu festzustellen. Dabei wurde folgendes gefunden. Bei allen Targets obiger Zusammensetzung kam es zu einer Verschiebung des Mo Peaks im Röntgenspektrum zu grösseren Winkeln 2Theta hin wie es in Abbildung 5a und b für die Oberfläche des Mo(95at.%)-Cu(5at.%) dargestellt ist. Diese Verschiebung war weitgehend unabhängig von der Targetzusammensetzung. Andererseits ergab sich, verglichen mit der Intensität des ursprünglichen Cu Signals beim unbehandelten Target, eine deutliche Reduktion desselben, die teilweise (aber nicht immer) so stark war, dass mit XRD in der Theta/2Theta Anordnung überhaupt kein Cu mehr nachgewiesen werden konnte.

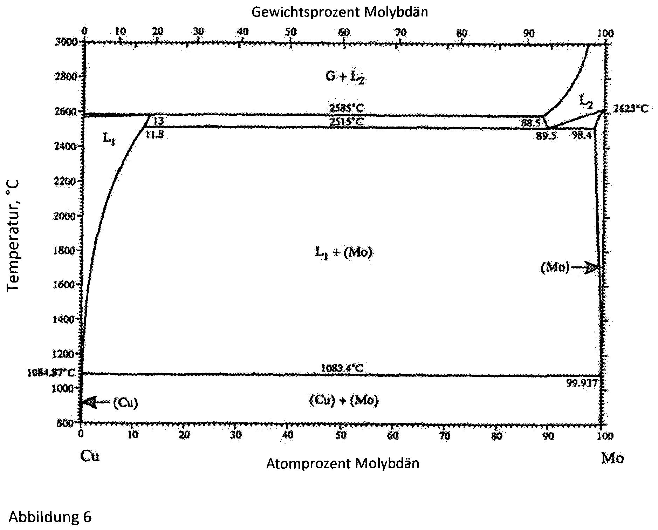

Die Peakverschiebung im XRD-Spektrum des Mo kann durch die Bildung eines Mo-Cu Mischkristalls erklärt werden, falls man einem Cu Anteil zwischen etwa 2 und 3 at.% annimmt. Das ist in erstaunlicher Übereinstimmung mit dem Mo-Cu-Phasendiagramm, das die Möglichkeit der Bildung eines solchen Mischkristalls zulässt, aber natürlich nur für (thermische) Gleichgewichtszustände anwendbar ist und deshalb eigentlich nicht für die Funkenverdampfung zutrifft. Falls man aber doch das Mo-Cu Phasendiagramm (Abbildung 6) zu einer Plausibilitätserklärung heranziehen will, könnte man argumentieren, dass (in Abhängigkeit der Temperatur) nur begrenzte Mengen Cu (bis etwa zu 3 at.%) im Mo gelöst werden können. Grössere Mengen an Cu, falls sie sich im Target befinden, können über den ganzen Temperaturbereich der festen Mo-Phase nicht in Mo gelöst werden, d.h. sie werden gezwungenermassen als Cu ausgeschieden. Das bedeutet aber, dass der durch den kathodischen Funken stattfindende Aufschmelz-Abkühlvorgang breite Temperaturbereiche überstreicht, in denen gleichzeitig die flüssige Cu-Phase und die feste Phase des Mo vorliegt. Das ist also eine Folge der begrenzten Löslichkeit des Cu im Mo und der voneinander sehr unterschiedlichen Schmelzpunkte. Die Dampfdrucke der beiden Materialien unterscheiden sich ebenfalls sehr stark. Jedenfalls wird angenommen, dass diese Tatsachen zu folgenden Ergebnissen beitragen:
- Es kann bei der Targetfertigung keine innige Verbindung zwischen dem Mo und dem Cu im Target hergestellt werden, besonders nicht für Cu-Gehalte über ca. 4 at.%.
- Die Targetoberfläche wird von einer Mo-Oberfläche zu einer Mo-Cu-Mischkristall-Oberfläche durch die Einwirkung des kathodischen Funkens transformiert.
- Überschüssige Cu-Anteile werden in relativ zum Mo grösserem Masse (unterschiedlicher Dampfdruck) von der Targetoberfläche abgedampft und führen zu einer Verarmung des Cu an der äussersten Targetoberfläche.
- Die sehr unterschiedlichen Schmelztemperaturen führen zu Spritzern, deren genauer Bildungsprozess nicht klar ist. Möglicherweise könnten diese über ein Verflüssigen/Verdampfen des Cu unter der Targetoberfläche hervorgerufen werden, also bei Temperaturen, bei denen das Mo in fester Phase vorliegt, Cu aber flüssig ist.

Zusammenfassend kann man sagen, dass die begrenzte Löslichkeit des Cu im Mo und die Koexistenz von flüssiger Cu-Phase und fester Mo-Phase über breite Temperaturbereiche zur vermehrten Spritzergenerierung führen. Beeinflusst werden kann die Spritzergenerierung über den Cu-Gehalt.

Dieses Verhalten gilt nicht nur für das Mo-Cu-Materialsystem, sondern auch noch für andere Materialsysteme, die in ganz ähnlicher Weise solche Spritzer generieren. Diese sind in Tabelle 1 angegeben. Für in der Tabelle eingeklammerte Elemente wurden keine Daten in der Literatur gefunden, eignen sich aber vermutlich in der Kombination. Gestrichene Elemente haben einen für die Targetproduktion zu niedrigen Schmelzpunkt, sind giftig oder radioaktiv. Die als Matrixelemente bezeichneten Elemente sind dabei jene hochschmelzenden Elemente aus denen die spätere Schichtmatrix formiert wird. Diese Schichtmatrix kann entweder metallisch sein oder eine Verbindung mit C, N, O oder Kombinationen dieser Elemente umfassen. Die Dotierelemente bestimmen wesentlich den Prozess der Spritzergenerierung über ihre Konzentration im Target. Die zwei Materialgruppen, die Matrixelemente und die Dotierungen, für die dieses Verhalten zutrifft, sind in den Tabellen 2 und 3 charakterisiert.

In Tabelle 2 sind die Schmelzpunkte der Matrixelemente und die Temperaturen angegeben, bei denen sich etwa ein Dampfdruck von 10-2 Torr einstellt, d.h. unter Bedingungen bei denen schon merkbare Mengen verdampfen. Für die meisten Matrixelemente liegt diese Temperatur in der Nähe der Schmelztemperatur.

In Tabelle 3 sind die entsprechenden Werte für die Dotierelemente angegeben. Man sieht im Vergleich, dass es zwischen den Matrixelementen und den Dotierelementen typischerweise sowohl für die Schmelztemperatur wie auch für die Temperaturen, bei denen sich ein Dampfdruck von 10-2 Torr einstellt, eine Temperaturdifferenz von ungefähr 1000°C gibt.

Es könnte nun die Vermutung entstehen, dass sich alle Targets aus einem hochschmelzenden Material mit beispielsweise Cu-Dotierungen wie das Mo-Cu-Target verhalten. Das konnte aber nicht bestätigt werden. Beispielsweise trifft das nicht für Zr-Cu-, Hf-Cu- oder Ti-Cu-Materialsystem zu. Bei der Verdampfung dieser Materialsysteme mittels Funken entstehen zwar Spritzer, aber diese werden weitaus besser in die synthetisierte Schicht eingebaut und nicht herausgedrückt wie es für das Mo-Cu-System oben beschrieben wurde. Auch für andere niedrigschmelzende Dotierungen in hochschmelzenden Matrixelementen wie beispielsweise Ag in Pt ist dies der Fall. Auch Al als niedrigschmelzendes Material zeigt dieses weder in Kombination mit Mo, Ta, W, V oder Zr und ist trotz seiner Weichheit als Dotiermaterial in allen bisher getesteten Kombinationen ungeeignet. Dafür, dass diese Materialkombinationen nicht geeignet sind, könnte man wieder das Phasendiagramm für die Basis einer Plausibilitätserklärung heranziehen, natürlich wieder mit der schon oben angeführten Gültigkeitseinschränkung. Bei allen binären Materialsystemen, bei denen es nicht zu einer Koexistenz zwischen fester Phase des Matrixelements und der flüssigen Phase des Dotierungselements über einen breiten Temperaturbereich kommt, weil sich beim Übergang von der Liquiduslinie zu tieferen Temperaturen hin intermetallische Verbindungen und/oder Mischkristalle aus Matrixelement und Dotierelement ergeben, ist der Vorgang der Schichtstrukturierung über die Spritzer weniger ausgeprägt und die Spritzer haben eine grössere Neigung, um in der Schicht haften zu bleiben und überwachsen zu werden.

Im Folgenden soll nun noch der lose Einbau der Spritzer auf der Substratseite, also in die Schicht diskutiert werden. Auch hier können nur Vermutungen angestellt werden wie es bei der Spritzerentstehung weiter oben der Fall war. Es wurde nachgewiesen, dass die Spritzer nicht an Cu verarmt sind wie es die Targetoberfläche nach dem Einschmelzvorgang ist. Das schnelle Herausschleudern der Spritzer aus der Targetoberfläche verhindert ein vollständiges Aufschmelzen der Spritzer und es bleibt in ihnen annähernd die ursprüngliche Targetzusammensetzung erhalten. Das würde bedeuten, dass die Spritzer beim Auftreffen auf eine heisse Oberfläche Cu ausscheiden, das wegen des niedrigen Schmelzpunktes und des hohen Dampfdruckes keine gute Haftung auf der Matrixschichtoberfläche zuliesse. Denkbar ist aber auch noch ein anderer Effekt, den man auf die Prozesse an der Targetoberfläche zurückzuführen könnte. Beim schnellen Abkühlen der durch den Funken aufgeschmolzenen Bereiche verfestigt sich aus der Schmelze zuerst Mo bzw. der Mo-Cu-Mischkristall. Das ausgeschiedene Cu ist dabei immer noch in der flüssigen Phase und wird bei den hohen Temperaturen entsprechend verdampft. Ein grosser Teil des Dampfes kondensiert und wird offensichtlich in die Schicht eingebaut (Messungen ergaben, dass die Schichtzusammensetzung etwa der nominalen, also ursprünglichen Targetzusammensetzung entspricht), wobei die Art und Weise des Cu-Einbaus von den spezifischen Reaktionen abhängt, die mit dem Prozessgas und dem Matrixelement stattfinden können. Es ist aber auch denkbar, dass ein Teil des Cu nicht eingebaut werden kann und an der Oberfläche der wachsenden Schicht ausgeschieden wird. Spritzer könnten dann weniger gut auf der mit Cu besetzten Oberfläche anhaften.

Wie bereits erwähnt kann eine Oberflächenstrukturierung, die auf der beschriebenen Methode und den Targetmaterialien beruht, sehr breit angewendet werden, beispielsweise um die Benetzungseigenschaften von Oberflächen zu optimieren. Näher wurden im Rahmen dieser Erfindung jedoch Anwendungen untersucht, die sich auf das Gebiet der Tribologie beziehen. Es wurden beispielsweise Bauelemente von Verbrennungsmotoren beschichtet und deren Verschleiss und untersucht. Dabei zeigte es sich, dass eine Mo-Cu-N Schicht den Verschleiss unter geschmierten Bedingungen sowohl vom beschichteten Körper als auch vom unbeschichteten Gegenkörper drastisch reduzierte.

Die dabei angewendete Oberflächenstrukturierung wies folgende Eigenschaften auf:
- Die Matrixschichten waren vorzugsweise eine Hartstoffschicht sein mit einer HIT von mehr als 20 GPa, vorzugsweise mehr als 25 GPa.
- Die Matrixschicht wies selbstschmierende Eigenschaften in der Anwendung auf, was ein Versagen auch unter Bedingungen der Mangelschmierung verhinderte.
- Die Matrixschicht konnte leicht mit einer Standardnachbehandlung von den Spritzern befreit werden.
- Mit dieser Standardnachbehandlung wurde eine Schichtoberfläche geschaffen, die "Tälerstruktur" aufwies und geeignet ist, um Schmiermittel aufzunehmen.

Im Rahmen der vorliegenden Beschreibung wurde ein Beschichtungsverfahren auf der Basis der Abscheidung aus der Gasphase mittels Funkenverdampfen offenbart, mit den Schritten
- Auswahl eines ersten Targets als Materialquelle für die Beschichtung
- Bereitstellung einer Beschichtungskammer mit Funkenverdampfungsquelle die zumindest das ausgewählte Target umfasst
- Beladen der Beschichtungskammer mit zu beschichtenden Substraten
- Abpumpen der Beschichtungskammer auf einen für die Funkenverdampfung geeigneten Prozessdruck
- Zünden und betreiben des Funkens so dass vom ersten Target Material verdampft wird welches sich auf den zu beschichtenden Substraten niederschlägt, gegebenenfalls nach Reaktion mit einem in die Beschichtungskammer eingelassenen Reaktivgas
dadurch gekennzeichnet, dass das erste Target zumindest einen solchen Matrixbestandteil und einen solche Dotierungsbestandteil umfasst dass der Dotierungsbestandteil einen um mindestens 600°C niedrigeren Schmelzpunkt als der Matrixbestandteil aufweist und ein geschmolzener Tropfen des Dotierungsbestandteils eine feste Oberfläche des Matrixberstandteils nicht benetzt.

Beim Beschichtungsverfahren kann ein geschmolzener Tropfen des Dotierungsbestandteils auf der festen Oberfläche des Matrixberstandteils einen Kontaktwinkel von mindestens 90° einnimmt.

Bei dem Beschichtungsverfahren kann das erste Target so gewählt werden, dass der Matrixbestandteil aus mindestens einem der Elemente aus einer ersten Gruppe gebildet durch Ir, Mo, Nb, Os, Re, Rh, Ta, Ti, V, W, Zr oder deren Legierungen besteht.

Bei dem Beschichtungsverfahren kann das erste Target so gewählt werden, dass der Dotierungsbestandteil aus mindestens einem Element aus einer zweiten Gruppe gebildet durch Ag, Ca, Ce, Cu, Dy, Er, Eu, Gd, La, Mg, Nd, Pb, Sb, Sm, Sr, TI, Y, Yb, Zn oder deren Legierungen besteht.

Bei dem Beschichtungsverfahren kann das erste Target so gewählt werden, dass die Kombination aus Matrixbestandteil und Dotierungsbestandteil so vorliegt, dass deren Schmelzpunkte sich um mindestens 800°C, bevorzugt um mindestens 1000°C unterscheiden.

Bei dem Beschichtungsverfahren kann das erste Traget so gewählt werden, dass im ersten Target der Dotierungsbestandteil in einer höheren Konzentration vorliegt als er mit dem Matrixbestandteil gemäss Phasendiagramm einen Mischkristall bilden kann.

Bei dem Beschichtungsverfahren wird vorteilhafter Weise zunächst von einem zweiten Target beschichtet, welches im Wesentlichen keinen Dotierungsbestandteil umfasst und zum Aufbringen einer Deckschicht vom ersten Target beschichtet wird.

Es wurde ein Verfahren zur Herstellung einer strukturierten Schicht offenbart, dadurch gekennzeichnet, dass ein Beschichtungsverfahren nach einem der vorangehenden Ansprüche ausgeführt wird und die so entstandene Schicht poliert wird so dass die an der Schichtoberfläche liegenden Spritzer zumindest teilweise entfernt werden und Einformungen mit im Wesentlichen kreisrundem Durchmesser hinterlassen.

Bei diesem Verfahren können die Spritzer teilweise in die Einformungen geschmiert werden.

Es wurde ein Target offenbart, welches als Materialquelle für eine PVD Beschichtung geeignet ist, wobei das zumindest einen solchen Matrixbestandteil und einen solche Dotierungsbestandteil umfasst dass der Dotierungsbestandteil einen um mindestens 600°C niedrigeren Schmelzpunkt als der Matrixbestandteil aufweist und ein geschmolzener Tropfen des Dotierungsbestandteils eine festen Oberfläche des Matrixberstandteils nicht benetzt und vorzugsweise einen Kontaktwinkel von mindestens 90° einnimmt.

Im Target kann die Konzentration des Dotierungsbestandteils an der Targetoberfläche um mindestens 25% im Vergleich zu der Konzentration des Dotierungsbestandteils an einer Referenztelle niedriger sein, wobei als Referenzelle auf halbem Weg von der Targetoberfläche zur Targetrückseite angesiedelt ist.

Es wurde ein mit einem Schichtsystem beschichtetes Substrat offenbart, wobei das Schichtsystem zumindest eine Schicht umfasst welche für das Funkenverdampfen charakteristische Spritzer ausweist, dadurch gekennzeichnet, dass die Oberfläche der Schicht Einformungen mit im Wesentlichen kreisrunden Durchmessern aufweist die in der Mehrzahl in der Grössenordnung von einem bis mehreren hundert Nanometer liegen.

Beim Substrat kann die Oberfläche der Schicht durch eine Deckschicht gebildet werden und zwischen Deckschicht und Substrat zumindest eine weitere Schicht angeordnet sein welche eine Spritzerdichte aufweist die eine geringere Spritzerintensität während des Beschichtens im Vergleich zur Oberfläche dokumentiert.

### Tabellen

**Tabelle 1**

| Matrix-Elemente | Doping-Elemente |
|---|---|
| Ir | Ag, Cu |
| Mo | Ag, Ca Ce, Cu, Dy, Er, Eu, Gd, La, Mg, Nd, Pb, Sm, Sr, Tl, Yb, Zn, und deren Legierungen |
| Nb | Ag, (Ca), Cu, Ce, Eu, Mg, (Sr), Tl, Yb, und deren Legierungen |
| Os | Ag, Cu |
| Re | Ag, Cu, Sb, und deren Legierungen |
| Rh | Ag |
| Ta | (Ca), Ce, Cu, Dy, Eu, Gd, La, (Mg), Sm, Tl, Yb, und deren Legierungen |
| Ti | (Ca), Ce, Dy, Eu, und deren Legierungen |
| V | Ag, Ca, Ce, Cu, Dy, Er, Eu, Gd, La, Mg, Nd, Sm, Sr, Tl, Yb, und deren Legierungen |
| W | Ag, (Ca), Ce, Cu, Dy, Er, Eu, Gd, La, (Mg), Nd, Pb, Sb, Sm, (Sr), Y, Yb, und deren Legierungen, |
| Zr | (Ca), (Ce), Eu, Mg, und deren Legierungen |

**Tabelle 2**

| Matrix Element | T_{SM} [C] | T [C] for 10⁻² Torr Dampfdruck |
|---|---|---|
| Ir | 2466 | 2307 (NES) |
| Mo | 2623 | 2527 |
| Nb | 2477 | 2657 |
| Os | ca. 3130 | ca. 2700 (NES) |
| Re | 3186 | 3067 |
| Rh | 3695 | 2037 |
| Ta | 3017 | 3057 |
| Ti | 1668 | 1737 |
| V | 1910 | ca. 2100 (NES) |
| W | 3422 | 3227 |
| Zr | 1857 | ca. 2700 (NES) |

**Tabelle 3**

| Doping Element | T_{SM} [C] | T [C] for 10⁻² Torr Dampfdruck |
|---|---|---|
| Ag | 962 | 1027 |
| Ca | 842 | 597 |
| Ce | 795 | Ca. 1450 (NES) |
| Cu | 1085 | 1257 |
| Dy | 1407 | 1117 |
| Er | 1529 | 1177 |
| Eu | 826 | 611 |
| Gd | 1312 | Ca. 700 (NES) |
| La | 920 | 1727 |
| Mg | 650 | 439 |
| Nd | 1024 | Ca. 1400 (NES) |
| Pb | 327 | 715 |
| Sb | 631 | 533 |
| Sm | 1072 | Ca. 750 (NES) |
| Sr | 777 | 537 |
| Tl | 304 | 609 |
| Y | 1526 | 1632 |
| Yb | 824 | 557 |
| Zn | 420 | 344 |

**Tabelle 4**

| Matrix Element | oxide | nitride |
|---|---|---|
| Ir | ? | ? |
| Mo | < 1000 | < 1000 |
| Nb | liquid | |
| Os | | |
| Re | | |
| Rh | | |
| Ta | liquid | |
| Ti | liquid | |
| V | < 1000 | |
| W | < 1000 | |
| Zr | | |

## Patentansprüche

1. Verfahren zur Beschichtung eines Substrats mit einer Schicht mit strukturierter Oberfläche, wobei die Schicht durch Abscheidung mittels Funkenverdampfen mit den folgenden Schritten hergestellt wird:
- Auswahl eines ersten Targets als Materialquelle für die Beschichtung,
- Bereitstellung einer Beschichtungskammer mit einer Funkenverdampfungsquelle die zumindest das erste Target umfasst,
- Beladen der Beschichtungskammer mit dem zu beschichtenden Substrat,
- Abpumpen der Beschichtungskammer auf einen für die Funkenverdampfung geeigneten Prozessdruck
- Zünden und betreiben des Funkens, so dass vom ersten Target Material verdampft wird welches sich, gegebenenfalls nach Reaktion mit einem in die Beschichtungskammer eingelassenen Reaktivgas, auf dem Substrate als Schicht niederschlägt,
wobei das erste Target zumindest einen hochschmelzenden Matrixbestandteil, der aus mindestens einem Matrixelement, und zumindest einen niederschmelzenden Dotierungsbestandteil, der aus mindestens einem Dotierelement besteht, umfasst und
der Dotierungsbestandteil einen um mindestens 600°C niedrigeren Schmelzpunkt als der Matrixbestandteil aufweist, und ein geschmolzener Tropfen des Dotierungsbestandteils eine feste Oberfläche des Matrixbestandteils nicht benetzt, **dadurch gekennzeichnet, dass**
- der Dotierungsbestandteil im ersten Target in einer höheren Konzentration vorliegt als er mit dem Matrixbestandteil gemäss Phasendiagramm einen Mischkristall bilden kann,
- wobei der Matrixbestandteil aus mindestens einem der Elemente aus einer ersten Gruppe gebildet durch Ir, Mo, Nb, Os, Re, Rh, Ta, Ti, V, W, Zr oder deren Legierungen besteht, und
- der Dotierungsbestandteil aus mindestens einem Element aus einer zweiten Gruppe gebildet durch Ag, Ca, Ce, Cu, Dy, Er, Eu, Gd, La, Mg, Nd, Pb, Sb, Sm, Sr, Ti, Y, Yb, Zn oder deren Legierungen besteht,
- wobei die Materialkombination aus Matrixbestandteil und Dotierungsbestandteil weder das Materialsystem Zr-Cu noch das Materialsystem Ti-Cu umfasst.
wodurch während der Abscheidung der Schicht Spritzer nur lose in die Schicht eingebaut und entweder selbständig aus der Schicht herausgedrückt werden oder nachträglich durch eine einfache Nachbehandlung entfernt werden können, wodurch konkave Strukturen in die Schichtoberfläche eingebracht werden.

2. Verfahren nach Anspruch 1 **dadurch gekennzeichnet, dass** ein geschmolzener Tropfen des Dotierungsbestandteils auf der festen Oberfläche des Matrixberstandteils einen Kontaktwinkel von mindestens 90° einnimmt, wodurch ein fast kugelförmiger Tropfen entsteht.

3. Verfahren nach einem der vorhergehenden Ansprüche, **dadurch gekennzeichnet, dass**
- die erste Gruppe Ir und die zweite Gruppe Ag und/oder Cu umfasst oder
- die erste Gruppe Mo und die zweite Gruppe Ag, Ca, Ce, Cu, Dy, Er, Eu, Gd, La, Mg, Nd, Pb, Sm, Sr, TI, Yb und/oder Zn umfasst oder
- die erste Gruppe Nb und die zweite Gruppe Ag, Ca, Cu, Ce, Eu, Mg, Sr, TI, Yb, und/oder deren Legierungen umfasst oder
- die erste Gruppe Os und die zweite Gruppe Ag, Cu und/oder deren Legierungen umfasst oder
- die erste Gruppe Re und die zweite Gruppe Ag, Cu, Sb und/oder deren Legierungen umfasst oder
- die erste Gruppe Rh und die zweite Gruppe Ag umfasst oder
- die erste Gruppe Ta und die zweite Gruppe Ca, Ce, Cu, Dy, Eu, Gd, La, Mg, Sm, TI, Yb und/oder deren Legierungen umfasst oder
- die erste Gruppe Ti und die zweite Gruppe Ca, Ce, Dy, Eu und/oder deren Legierungen umfasst oder
- die erste Gruppe V und die zweite Gruppe Ag, Ca, Ce, Cu, Dy, Er, Eu, Gd, La, Mg, Nd, Sm, Sr, Y, Yb und/oder deren Legierungen umfasst oder
- die erste Gruppe W und die zweite Gruppe Ag, Ca, Ce, Cu, Dy, Er, Eu, Gd, La, Mg, Nd, Pb, Sb, Sm, Sr, Y, Yb und/oder deren Legierungen umfasst oder
- die erste Gruppe Zr und die zweite Gruppe Ca, Ce, Eu, Mg und/oder deren Legierungen umfasst.

4. Verfahren nach einem der vorangehenden Ansprüche, **dadurch gekennzeichnet, dass** das erste Target so gewählt wird, dass die Kombination aus Matrixbestandteil und Dotierungsbestandteil so vorliegt, dass deren Schmelzpunkte sich um mindestens 800°C unterscheiden.

5. Verfahren nach einem der vorangehenden Ansprüche, **dadurch gekennzeichnet, dass** zunächst von einem zweiten Target beschichtet wird, welches keinen Dotierungsbestandteil umfasst und zum Aufbringen einer Deckschicht das erste Target verwendet wird.

6. Verfahren nach einem der vorangehenden Ansprüche **dadurch gekennzeichnet, dass** die so entstandene Schicht poliert wird so dass die an der Schichtoberfläche liegenden Spritzer zumindest teilweise entfernt werden und Einformungen mit kreisrundem Durchmesser hinterlassen.

7. Verfahren nach Anspruch 6, **dadurch gekennzeichnet, dass** die Spritzer teilweise in die Einformungen geschmiert werden.

8. Verfahren nach einem der vorangehenden Ansprüche, **dadurch gekennzeichnet, dass** das erste Target ein Mo-Cu-Target ist.

9. Verfahren nach Anspruch 8, **dadurch gekennzeichnet, dass** der Cu-Gehalt des Mo-Cu-Targets grösser 4 at% und kleiner oder gleich 30 at% ist.

10. Mit einem Schichtsystem beschichtetes Substrat wobei das Schichtsystem zumindest eine Schicht umfasst, die nach einem der Ansprüche 1 bis 9 beschichtet ist, **dadurch gekennzeichnet, dass** die Oberfläche der Schicht Einformungen mit kreisrunden Durchmessern aufweist, die in der Mehrzahl in der Grössenordnung von einem bis mehreren hundert Nanometer liegen, um Schmiermittel aufzunehmen, wobei in der Lochstruktur der Schichtmatrix teilweise Spritzermaterial vorliegt.

11. Substrat nach Anspruch 10, **dadurch gekennzeichnet, dass** die Schicht eine Deckschicht der Oberfläche des Schichtsystems bildet und zwischen Deckschicht und Substrat zumindest eine weitere Schicht angeordnet ist welche eine Spritzerdichte aufweist die eine geringere Spritzerintensität während des Beschichtens im Vergleich zur Oberfläche aufweist.

## Claims

1. Method for coating a substrate with a layer with structured surface, wherein the layer is produced by deposition by means of spark evaporation with the following steps:
- selection of a first target as material source for the coating,
- provision of a coating chamber with a spark evaporation source comprising at least the first target,
- loading the coating chamber with the substrate to be coated,
- pumping the coating chamber to a process pressure suitable for the spark evaporation
- igniting and operating of the spark so that material is evaporated from the first target which, if necessary after reaction with a reactive gas introduced into the coating chamber, deposits on the substrate as a layer,
wherein the first target comprises at least one refractory matrix component consisting of at least one matrix element and at least one low-melting doping component that consists of at least one doping element, and the doping component has a melting point at least 600°C lower than the matrix component, and a melted drop of the doping component does not wet a solid surface of the matrix component, **characterized in that**
- the doping component in the first target is present in a higher concentration than it could form a solid solution with the matrix component according to phase diagram,
- wherein the matrix component consists of at least one of the elements of a first group formed by Ir, Mo, Nb, Os, Re, Rh, Ta, Ti, V, W, Zr or alloys thereof, and
- the doping component consists of at least one element of a second group formed by Ag, Ca, Ce, Cu, Dy, Er, Eu, Gd, La, Mg, Nd, Pb, Sb, Sm, Sr, Ti, Y, Yb, Zn or alloys thereof,
- wherein the material combination of matrix component and doping component comprises neither the material system Zr-Cu nor the material system Ti-Cu
whereby splashers are only loosely incorporated into the layer during the layer deposition and are either independently squeezed out of the layer or can retrospectively be removed by a simple post-treatment by which concave structures are introduced into the layer surface.

2. Method according to claim 1 **characterized in that** a melted drop of the doping component takes a contact angle of at least 90° on the solid surface of the matrix component, creating an almost spherical drop.

3. Method according to any of the foregoing claims, **characterized in that**
- the first group comprises Ir and the second group comprises Ag and/or Cu or
- the first group comprises Mo and the second group comprises Ag, Ca, Ce, Cu, Dy, Er, Eu, Gd, La, Mg, Nd, Pb, Sm, Sr, Tl, Yb and/or Zn or
- the first group comprises Nb and the second group comprises Ag, Ca, Cu, Ce, Eu, Mg, Sr, Tl, Yb and/or alloys thereof or
- the first group comprises Os and the second group comprises Ag, Cu and/or alloys thereof or
- the first group comprises Re and the second group comprises Ag, Cu, Sb and/or alloys thereof or
- the first group comprises Rh and the second group comprises Ag or
- the first group comprises Ta and the second group comprises Ca, Ce, Cu, Dy, Eu, Gd, La, Mg, Sm, Tl, Yb and/or alloys thereof or
- the first group comprises Ti and the second group comprises Ca, Ce, Dy, Eu and/or alloys thereof or
- the first group comprises V and the second group comprises Ag, Ca, Ce, Cu, Dy, Er, Eu, Gd, La, Mg, Nd, Sm, Sr, Y, Yb and/or alloys thereof or
- the first group comprises W and the second group comprises Ag, Ca, Ce, Cu, Dy, Er, Eu, Gd, La, Mg, Nd, Pb, Sb, Sm, Sr, Y, Yb and/or alloys thereof or
- the first group comprises Zr and the second group comprises Ca, Ce, Eu, Mg and/or alloys thereof.

4. Method according to any of the foregoing claims, **characterized in that** the first target is chosen in a way that the combination of matrix component and doping component is so that their melting points differ by at least 800°C.

5. Method according to any of the foregoing claims, **characterized in that** it is first coated from a second target which does not comprise any doping component and the first target is used for depositing a top layer.

6. Method according to any of the foregoing claims, **characterized in that** the formed layer is polished so that the splashers lying at the layer surface are removed at least partially and leave recesses with circular diameter.

7. Method according to claim 6 **characterized in that** the splashers are partially lubricated into the recesses.

8. Method according to any of the foregoing claims, **characterized in that** the first target is a Mo-Cu target.

9. Method according to claim 8, **characterized in that** the Cu content of the Mo-Cu target is higher than 4at% and lower or equal 30at%.

10. Substrate coated with a layer system wherein the layer system comprises at least one layer coated according to any of the claims 1 to 9, **characterized in that** the surface of the layer has recesses with circular diameters, the majority of which are in the order of one to several hundred nanometer, to receive lubricant, wherein splasher material is partially present in the hole structure of the layer matrix.

11. Substrate according to claim 10, **characterized in that** the layer forms a top layer of the surface of the layer system and at least one further layer is arranged between top layer and substrate, which has a splasher density that, in comparison to the surface, has a lower splasher intensity during the coating.

## Revendications

1. Procédé pour revêtir un substrat d'une couche avec une surface structurée, la couche étant fabriquée par dépôt au moyen d'une vaporisation par étincelles comprenant les étapes suivantes consistant à :
- choisir une première cible comme source de matériau pour le revêtement,
- fournir une chambre de revêtement avec une source de vaporisation par étincelles qui comprend au moins la première cible,
- charger la chambre de revêtement avec le substrat à revêtir,
- pomper la chambre de revêtement à une pression de processus adaptée à la vaporisation par étincelles,
- allumer et utiliser l'étincelle de manière à ce que du matériau soit vaporisé par la première cible, lequel se dépose sur le substrat sous forme de couche, le cas échéant après réaction avec un gaz réactif admis dans la chambre de revêtement,
dans lequel la première cible comprend au moins un composant de matrice à point de fusion élevé constitué d'au moins un élément de matrice et au moins un composant de dopage à point de fusion bas constitué d'au moins un élément de dopage, dans lequel le composant de dopage présente un point de fusion inférieur à celui du composant de matrice d'au moins 600 °C, et dans lequel une goutte fondue du composant de dopage ne mouille pas une surface solide du composant de matrice, **caractérisé en ce que** :
- le composant de dopage est présent dans la première cible à une concentration supérieure à celle à laquelle il peut former un cristal mixte avec le composant de matrice selon le diagramme de phase,
- le composant de matrice est constitué d'au moins un élément issu d'un premier groupe formé par Ir, Mo, Nb, Os, Re, Rh, Ta, Ti, V, W, Zr ou des alliages de ces derniers, et
- le composant de dopage est constitué d'au moins un élément issu d'un deuxième groupe formé par Ag, Ca, Ce, Cu, Dy, Er, Eu, Gd, La, Mg, Nd, Pb, Sb, Sm, Sr, Ti, Y, Yb, Zn ou des alliages de ces derniers,
- la combinaison du composant de matrice et du composant de dopage ne comprend ni le système de matériau Zr-Cu ni le système de matériau Ti-Cu,
ce qui fait que pendant le dépôt de la couche, les gouttelettes ne sont incorporées que de manière éparse dans la couche et peuvent soit être expulsées de la couche de manière autonome, soit être éliminées ultérieurement par un simple traitement ultérieur, permettant ainsi de former des structures concaves à la surface de la couche.

2. Procédé selon la revendication 1, **caractérisé en ce qu'**une goutte fondue du composant de dopage sur la surface solide du composant de matrice forme un angle de contact d'au moins 90°, ce qui donne une goutte presque sphérique.

3. Procédé selon l'une des revendications précédentes, **caractérisé en ce que**
- le premier groupe comprend Ir et le deuxième groupe comprend Ag et/ou Cu, ou
- le premier groupe comprend Mo et le deuxième groupe comprend Ag, Ca, Ce, Cu, Dy, Er, Eu, Gd, La, Mg, Nd, Pb, Sm, Sr, TI, Yb et/ou Zn, ou
- le premier groupe comprend Nb et le deuxième groupe comprend Ag, Ca, Cu, Ce, Eu, Mg, Sr, TI, Yb et/ou des alliages de ces derniers, ou
- le premier groupe comprend Os et le deuxième groupe comprend Ag, Cu et/ou des alliages de ces derniers, ou
- le premier groupe comprend Re et le deuxième groupe comprend Ag, Cu, Sb et/ou des alliages de ces derniers, ou
- le premier groupe comprend Rh et le deuxième groupe comprend Ag, ou
- le premier groupe comprend Ta et le deuxième groupe comprend Ca, Ce, Cu, Dy, Eu, Gd, La, Mg, Sm, TI, Yb et/ou des alliages de ces derniers, ou
- le premier groupe comprend Ti et le deuxième groupe comprend Ca, Ce, Dy, Eu et/ou des alliages de ces derniers, ou
- le premier groupe comprend V et le deuxième groupe comprend Ag, Ca, Ce, Cu, Dy, Er, Eu, Gd, La, Mg, Nd, Sm, Sr, Y, Yb et/ou des alliages de ces derniers, ou
- le premier groupe comprend W et le deuxième groupe comprend Ag, Ca, Ce, Cu, Dy, Er, Eu, Gd, La, Mg, Nd, Pb, Sb, Sm, Sr, Y, Yb et/ou des alliages de ces derniers, ou
- le premier groupe comprend Zr et le deuxième groupe comprend Ca, Ce, Eu, Mg et/ou des alliages de ces derniers.

4. Procédé selon l'une des revendications précédentes, **caractérisé en ce que** la première cible est choisie de manière à ce que la combinaison du composant de matrice et du composant de dopage soit telle que leurs points de fusion diffèrent d'au moins 800 °C.

5. Procédé selon l'une des revendications précédentes, **caractérisé en ce que** le revêtement initial est effectué par une deuxième cible qui ne comprend pas de composant de dopage, et **en ce que** la première cible est utilisée pour appliquer une couche de recouvrement.

6. Procédé selon l'une des revendications précédentes, **caractérisé en ce que** la couche ainsi obtenue est polie de manière à ce que les gouttelettes se trouvant à la surface de la couche soient au moins partiellement éliminées et laissent des empreintes de diamètre circulaire.

7. Procédé selon la revendication 6, **caractérisé en ce que** les gouttelettes sont partiellement lubrifiées dans les empreintes.

8. Procédé selon l'une des revendications précédentes, **caractérisé en ce que** la première cible est une cible Mo-Cu.

9. Procédé selon la revendication 8, **caractérisé en ce que** la teneur en Cu de la cible Mo-Cu est supérieure à 4 % at et inférieure ou égale à 30 % at.

10. Substrat revêtu d'un système de couches, le système de couches comprenant au moins une couche revêtue selon l'une des revendications 1 à 9, **caractérisé en ce que** la surface de la couche présente des empreintes de diamètres circulaires dont la majorité est de l'ordre de un à plusieurs centaines de nanomètres pour recevoir un lubrifiant, un matériau de vaporisation étant partiellement présent dans la structure à trous de la matrice de la couche.

11. Substrat selon la revendication 10, **caractérisé en ce que** la couche forme une couche de recouvrement de la surface du système de couches et **en ce qu'**au moins une autre couche est disposée entre la couche de recouvrement et le substrat, laquelle présente une densité de gouttelettes qui a une intensité de gouttelettes plus faible pendant le revêtement par rapport à la surface.
